# FASCICULE DE BREVET EUROPEEN

(11) **EP 2 004 564 B1**
(45) Date de publication et mention de la délivrance du brevet: **12.05.2010**
(21) Numéro de dépôt: 07731783.2
(22) Date de dépôt: 20.03.2007
(51) Int. Cl.: C03C 25/28, C08J 5/08, C08J 5/24, D04H 13/00, D04H 1/46, B29C 70/34, H05K 1/03

(54) **MAT DE VERRE AIGUILLETE**
VERNADELTE GLASMATTE
NEEDLED GLASS MAT

(30) Priorité: 24.03.2006 FR 0651034
(43) Date de publication de la demande: 24.12.2008
(73) Titulaire: OCV Intellectual Capital, LLC, Toledo, OH 43659 (US)
(72) Inventeur: ROEDERER, François, 73000 Chambery (FR); BASSANI, Emilio, 20045 Milan (IT)
(74) Mandataire: Intes, Didier Gérard André
(86) Numéro de dépôt international: PCT/FR2007/050968
(87) Numéro de publication internationale: WO 2007/113425

(56) Documents cités:
- WO-A-94/13473
- BE-A- 642 176
- DE-A1- 19 818 046
- FR-A1- 2 248 154
- FR-A1- 2 866 329
- JP-A- 8 012 380
- US-A- 3 097 963
- US-A- 4 518 653
- US-A- 5 437 928

## Description

L'invention concerne un nouveau mat de fils de verre utilisable pour le renforcement de matériaux composites préparés notamment par injection (procédé dit RTM de l'anglais « Resin Transfer Moulding ») ou préparés à partir de préimprégné en feuille (synonyme de SMC de l'anglais Sheet Molding Compound). On peut également imprégner directement le mat selon l'invention par une résine thermodurcissable, notamment pour réaliser des plaques translucides. Le procédé RTM et le procédé utilisant le préimprégné en feuille, font tous deux généralement appel aux matrices thermodurcissables. On n'exclut cependant pas d'utiliser le mat selon l'invention dans le cadre de la réalisation d'un composite à matrice thermoplastique, notamment du type polyuréthane, notamment par le biais du procédé RIM (de l'anglais « Reinforced Injection Molding »).

Grâce à l'invention, les composites réalisés sont particulièrement translucides, et l'on ne distingue pas ou peu les fils par transparence dans le composite.

Un mat pour le renforcement de matériaux composites doit présenter de préférence les propriétés suivantes :
- avoir une cohésion suffisante pour être enroulable, déroulable (pour le stockage et le transport),
- avoir une cohésion suffisante pour être découpé en morceaux, tenu à la main et placé à la main dans le moule (RTM),
- ne pas piquer les mains quand on le manipule ou place dans le moule (RTM),
- se laisser facilement déformer à la main lorsqu'on le place manuellement dans le moule (RTM),
- conserver correctement la forme donnée à la main dans le moule (RTM),
- se laisser imprégner par la résine d'injection (RTM) ou du SMC (généralement du type polyester et parfois du type epoxy) le plus facilement possible,
- avoir une structure la plus homogène possible, en particulier sans trous ou autre particularité en surface pouvant provoquer une marque en surface du composite final,
- renforcer le plus possible le composite.

On souhaite de plus pouvoir le fabriquer
- à la plus grande vitesse possible,
- avec le moins d'étapes possibles,
- en utilisant le moins de produits chimiques possibles (comme les liants).

Le composite final doit généralement présenter la meilleure résistance aux chocs possible, le moins de porosité incontrôlée possible (pas de bulles de gaz involontairement emprisonnées), et le meilleur aspect de surface possible, notamment le chant (face étroite) des pièces finales, et être le plus transparent possible.

Le WO2005/054559 enseigne un procédé de préparation d'un mat comprenant
a) la dépose ou projection de fils sur un tapis défilant pour former une nappe desdits fils entraînée par ledit tapis, puis
b) l'aiguilletage par des aiguilles à barbes traversant ladite nappe et se déplaçant dans la direction de la nappe à sensiblement la même vitesse qu'elle lorsqu'elles la traversent, avec une densité de coups allant de 1 à 25 coups par cm².

Ce procédé mène à des mats d'excellente qualité pour le renforcement de matériaux composites. Cependant, la demanderesse a découvert que la nature de l'ensimage pouvait influencer le comportement du mat lors de l'aiguilletage. Alors qu'un ensimage standard de fibres minérales (notamment de verre) peut se traduire par la cassure de fils lors de l'aiguilletage, l'ensimage utilisé selon l'invention protège beaucoup mieux les fibres à l'aiguilletage, et donne au fil une meilleur flexibilité et une surface plus glissante et beaucoup moins de cassures de fils sont à déplorer. La cassure de fil à l'aiguilletage se traduit par des envols de particules dans l'atelier de fabrication, un inconfort à la manipulation (ça pique les mains), et par le fait que le mat se tienne moins bien. De plus, le pouvoir renforçant pour le composite est réduit.

La présente invention procure une amélioration à l'enseignement du WO2005/054559 dont le contenu est inclus par référence. La technique de dépose de fils continus en nappe sur un convoyeur plan a notamment été décrite dans les US3969171 et US4208000. Notamment, l'ensimage des fils de verre a pour fonction de faciliter la manipulation desdits fils par ces dispositifs. Notamment, l'ensimage protège les fils de la casse et favorise l'adhésion du fil sur les roues de ces dispositifs. Cette adhésion doit être ni trop forte, ni trop faible. Le fil ne doit pas trop glisser pour que l'on puisse optimiser sa tension entre les roues de ces dispositifs (comme celui de la figure 4 du US3936558).

Des compositions d'ensimage contenant une faible quantité de polyvinylpyrrolidone a été enseignée par FR2349622, US4140833, FR2413336, US5038555, US4448911, WO2005/012201.

L'invention concerne en premier lieu un mat de fils de verre ensimés par une composition comprenant de l'eau et dont l'extrait sec comprend 1 à 30% en poids d'un agent de couplage et 30 à 99% en poids de polyvinylpyrrolidone (PVP). Selon l'invention, on ensime les fils minéraux (notamment en verre) par cette composition d'ensimage. L'extrait sec de la composition peut également comprendre en plus, 0 à 79% en poids de lubrifiant (non PVP), notamment 5 à 70% en poids de lubrifiant, et de manière encore préférée 20 à 70% en poids de lubrifiant.

Notamment, l'agent de couplage peut être présent dans l'extrait sec à raison de 2 à 10% en poids. Notamment, La PVP peut être présente à raison de 30 à 90% en poids. Notamment, le lubrifiant (n'étant pas du type PVP) peut être présent à raison de 5 à 78% en poids.

Généralement, la composition (pouvant servir de composition d'ensimage) ne contient pas de résine epoxy.

L'agent de couplage est habituellement un organosilane chargé d'améliorer la liaison entre les fibres et la matrice du composite. Il est donc à choisir en fonction de la matrice (laquelle est généralement du type thermodurcissable).

Cet organosilane comprend généralement au moins un groupement réactif capable de réagir avec les groupements hydroxyle de surface des fibres minérales (notamment en verre) de façon à greffer l'organosilane modifié (modifié en ce qu'il a réagi par son groupement réactif et a donc perdu une partie dudit groupement réactif) à la surface des filaments. L'organosilane utilisé lors de l'ensimage est généralement le dérivé hydrolysé d'un alkoxysilane, lui-même comprenant généralement le groupement trialkoxysilane, c'est-à-dire -Si(OR)₃, R représentant un radical hydrocarboné tel qu'un radical méthyle ou éthyle ou propyle ou butyle.

L'organosilane peut donc par exemple être le dérivé hydrolysé de l'un des composés suivants :
- gamma-aminopropyltriéthoxysilane
- gamma-glycydoxypropyltriméthoxysilane
- methacryloxypropyltriméthoxysilane (souvent désigné par A174)

La polyvinylpyrrolidone peut avoir une masse moléculaire moyenne en poids allant de 6000 à 3 000 000, notamment entre 100 000 et 2 000 000.

Le lubrifiant est huileux au toucher. Le lubrifiant peut notamment être choisi dans la liste suivante :
- chlorure de cocotriméthylammonium
- chlorure de lithium
- sel d'ammonium cationique quaternaire
- ester alkylphénolethoxylé (notamment le stantex FT 504 de Cognis)
- arquad C35 (d'akzo Nobel par exemple)

De préférence, le lubrifiant est un polyethylenesterglycol (souvent noté PEG). Notamment, il peut s'agir du PEG 400 ML.

De préférence, la composition d'ensimage contient en plus un agent anti-mousse dont la teneur dans l'extrait-sec peut aller de 5 à 500 ppm en poids.

La composition d'ensimage contient de l'eau. La quantité d'eau est telle que l'extrait sec de la composition représente entre 0,5 et 10% en poids, et de préférence entre 0,8 et 6% en poids de la composition. Notamment, la demanderesse a découvert que la teneur en extrait sec de la composition d'ensimage peut être très basse, par exemple de l'ordre de 0,8 à 2% en poids, ce qui présente l'avantage d'occasionner un plus faible encrassement des organes de fonctionnement.

L'utilisation de fils continus mène à un avantage au niveau de l'aspect de surface et plus particulièrement du chant des composites finaux, et au niveau de l'homogénéité de la répartition des fibres dans le composite final. En effet, le chant des pièces moulées est beaucoup plus net, lisse et mieux formé que lorsque des fils coupés étaient utilisés. Il semble que l'utilisation de fils coupés implique qu'une quantité importante d'extrémités de fils coupés se retrouvent à la surface ou juste sous la surface des chants de pièces. Ce phénomène a pour origine le fait que les fils coupés ont naturellement une orientation parallèle aux faces principales du composite. Cette accumulation d'extrémités de fils coupés aux chants semble favoriser la présence de porosités aux chants au début du procédé. Les bulles formées se dilatent alors sous l'effet de la température (de l'ordre de 200°C pour la solidification de la résine thermodurcissable), ce qui tend à déformer l'aspect de la surface des chants. Il semble que l'utilisation de fils continus réduise considérablement ce phénomène. En effet, à la place d'une extrémité de fil à la surface (cas de l'utilisation de fils coupés), on aura plutôt une boucle de fil continu, ce qui va dans le sens d'une surface plus lisse.

Pour l'application SMC, le mat doit de plus pouvoir fluer aisément lors du moulage sous presse. Rappelons qu'un SMC se présente avant moulage sous la forme d'une feuille de préimprégné contenant une résine thermodurcissable, ladite feuille contenant en son milieu une nappe de fils de renforcement. Ces fils sont, selon l'art antérieur, systématiquement des fils coupés. En effet, dans le moule, le SMC est soumis à une pression et doit fluer aisément pour remplir tout le volume du moule sous l'effet de la pression. Pour l'homme du métier, ce fluage est possible du fait que les fils sont coupés et peuvent aisément se déplacer les uns par rapport aux autres. La surface de SMC avant pressage ne représente généralement que 30 % environ de la surface du composite final. On passe de 30% à 100% sous l'effet du pressage. Selon l'art antérieur, pour préparer un SMC, on projète des fils coupés sur une nappe défilante de pâte à base de résine, et l'on dépose une autre nappe de pâte par dessus pour emprisonner les fils coupés comme dans un sandwich. Le SMC est ensuite enroulé et stocké. On le déroule pour découper une pièce (généralement appelée « flan de préimprégné ») dont la surface représente 30% seulement de la surface de la pièce finale, on place ladite pièce dans un moule et l'on procède au moulage à chaud sous presse. La résine thermodurcissable durcit pendant ce traitement. Dans le cadre de la présente invention, on peut utiliser non pas des fils coupés mais des fils continus dans le cadre de la technologie SMC. En effet, la nappe de fils continus peut fluer suffisamment pendant le pressage du SMC. On peut utiliser le mat de fils selon l'invention (fils coupés ou continus) dans le cadre de la technique du SMC. L'utilisation de fils continus en SMC mène de plus à un avantage au niveau des surfaces et plus particulièrement des chants des composites finaux. En effet, le chant des pièces moulées est beaucoup plus net, lisse et mieux formé que lorsque des fils coupés sont utilisés. De plus, en cas d'utilisation de fil coupé, le fluage nécessaire du SMC pendant le moulage conduit à une orientation préférentielle des fils, ce qui peut engendrer des ondulations de surface. En effet, comme les fils coupés sont indépendants, ils suivent trop facilement les flux et s'orientent selon les lignes de flux. Les fils peuvent même s'agglomérer ou former des paquets en suivant trop ces flux. Au contraire, les fils continus résistent à toute orientation du fait de leur longueur, tout en suivant suffisamment l'expansion du SMC pendant le pressage. En conséquence, l'utilisation de fil continu conduit à une meilleure homogénéité du renforcement du composite. A taux de fibre identique, l'utilisation de fil continu conduit généralement à un composite ayant une rigidité supérieur de 5 à 12 % supérieur en comparaison avec une utilisation de fil coupé.

La fabrication d'un mat pour le renforcement des composites via le procédé RTM passe généralement par la dépose ou projection de fils fraîchement ensimés sur un tapis défilant. Cependant, le lit de fils n'a à ce stade pas de consistance et ne peut pas être manipulé. Il ne peut pas non plus être enroulé ni déroulé car ses différentes couches de fils se mélangeraient. On doit donc le lier, soit chimiquement, soit mécaniquement.

Pour le lier chimiquement, on lui applique un liant chimique du type thermoplastique ou thermodurcissable, généralement en poudre, et l'on procède ensuite à un traitement thermique qui fond le thermoplastique ou polymérise le thermodurcissable et finalement après refroidissement crée des pontages entre les fils. Cependant, ce liant confère un effet ressort à la structure du mat qui a alors tendance à ne pas maintenir certaines formes moins progressives (dans les coins du moule par exemples). D'autre part, on souhaite limiter l'usage de produits chimiques dans un esprit de respect de l'environnement. De plus, le traitement thermique de fusion du thermoplastique est à une température relativement élevée (220-250°C) ce qui conduit à une cuisson sévère de l'ensimage rendant les fils et donc le mat, plus raide et plus difficile à déformer (le réseau de verre est alors bloqué).

Pour lier mécaniquement un mat, on peut lui faire subir un aiguilletage classique. Cependant, cela conduit généralement à la cassure de fils, provoquant une baisse des propriétés mécaniques, ainsi qu'à la formation de pointes sortant d'au moins une face du mat. Ces pointes piquent alors les mains des manipulateurs. De plus, comme le mat avance alors que les aiguilles plantées dans le mat sont fixes à l'horizontale et ne se déplacent qu'à la verticale , cela provoque des perforations bien plus importantes que la section des aiguilles et cela tend à tordre les aiguilles. Ces perforations marquent la surface, ce qui se traduit par des défauts de surface dans la pièce finale. En effet, ces trous se remplissent de résine et du fait du retrait de la résine après polymérisation, des creux restent visibles en surface.

On connaît les mats comprenant une âme centrale en fibres frisées de polypropylène (PP) et des couches externes de fils de verre coupés, le tout étant lié par une couture en fil synthétique comme en polyester (PET). La fibre frisée tend à donner du volume au mat pour faciliter la pénétration de la résine et remplir l'entrefer du moule (espace entre les deux parties métalliques du moule). Cependant, ni le PET, ni la fibre de PP ne renforcent le composite. De plus, la couture est visible dans le composite final et les aiguilles utilisées pour la couture provoquent par ailleurs des trous en surface. Ces trous se remplissent de résine et du fait du retrait de la résine après polymérisation, des creux restent visibles en surface.

Selon l'invention, on réalise un aiguilletage particulier sur le mat, lui donnant suffisamment de consistance, ne cassant pas ou que très peu de fils, notamment du fait de son ensimage particulier, et ne formant pas de trous trop importants. Le mat selon l'invention est suffisamment déformable à la main à la température ambiante et il est très perméable à la résine. Selon l'invention, l'aiguilletage est réalisé par des aiguilles se déplaçant en même temps que le mat, avec sensiblement la même vitesse que le mat dans une direction parallèle à la direction de déplacement du mat. De plus, le nombre d'impacts d'aiguille est réduit et est au plus de 25 coups par cm², et de préférence au plus de 15 coups par cm², et de manière encore préférée au plus de 10 coups par cm². Généralement, le nombre d'impact d'aiguille est d'au moins 1 coup par cm² et de préférence d'au moins 2 coups par cm².

Rappelons que les mats et les feutres se différencient nettement dans la mesure où un mat est un objet plan, utilisable comme renfort, alors qu'un feutre est un objet ayant du volume, utilisable en isolation thermique. Un mat a généralement une épaisseur allant de 0,8 à 5 mm, et plus généralement de 1 à 3 mm, alors qu'un feutre est bien plus épais, et a généralement une épaisseur supérieur à 1 cm. Un feutre a habituellement une densité allant de 85 à 130 kg/m³. Un mat est beaucoup plus dense puisque sa densité peut être de l'ordre de 300 kg/m³ .Cependant, on n'exprime jamais la densité d'un mat en masse volumique mais en masse surfacique, en tant que renfort plan.

Ainsi l'invention concerne notamment un procédé de préparation d'un mat comprenant
a) la dépose ou projection de fils sur un tapis défilant pour former une nappe desdits fils entraînée par ledit tapis, puis
b) l'aiguilletage par des aiguilles à barbes traversant ladite nappe et se déplaçant dans la direction de la nappe à sensiblement la même vitesse qu'elle lorsqu'elles la traversent, avec une densité de coups allant de 1 à 25 coups par cm².

De préférence, au moins 1 barbe et de préférence 2 barbes de chaque aiguille traversent à chaque coup l'épaisseur du mat. De préférence, la profondeur de pénétration des aiguilles (longueur d'aiguille sortant du mat après l'avoir traversé) va de 5 à 20 mm. De préférence les aiguilles ont un diamètre (plus petit cercle contenant entièrement toute section de l'aiguille y compris les barbes) allant de 0,2 à 3 mm et de manière encore préférée 0,5 à 1,5 mm. Un tel aiguilletage mène à un mat manipulable, enroulable et déroulable, facilement déformable à la main dans le moule, ne piquant pas les mains, sans marques de trous en surface. Grâce à cet aiguilletage très particulier, on peut faire avancer le mat à de fortes vitesses, par exemple à au moins 2 mètres par minute et même au moins 5 mètres par minute et même au moins 8 mètres par minute. Généralement, la vitesse est d'au plus 35 voire au plus 30 mètres par minute, voir au plus 20 mètres par minute. Lors de la traversée du mat par les aiguilles, des fils sont pris dans les barbes et entraînés pour former des boucles en travers du mat, sans cassure des fils. Ces boucles lient le mat et se laissent facilement déformer tout en conservant la fonction de liant pendant la mise en place dans le moule. Ces boucles ne piquent pas les mains du fait de la non-cassure des fils.

Pour réaliser un tel aiguilletage on peut par exemple utiliser certaines pré-aiguilleteuses à cylindre normalement conçues pour traiter les feutres de fibres polymère, comme par exemple la machine référencée PA169 ou PA1500 ou PA2000 commercialisée par Asselin (groupe NSC). Dans ce type de machine, les aiguilles décrivent un mouvement elliptique avec une composante horizontale permettant aux aiguilles dans le mat de le suivre dans son déplacement.

Le mat selon l'invention a généralement une masse surfacique allant de 50 à 3000 g/m². Il peut s'agir d'un mat à fils coupés ou d'un mat à fils continus. Ainsi, avant l'aiguilletage, on dépose ou projette sur le tapis défilant en direction de l'aiguilleteuse des fils coupés, généralement de longueur comprise entre 10 et 600 mm et plus particulièrement 12 à 100 mm , ou des fils continus. Dans le cas de fils continus, ceux-ci, dont le nombre peut aller de 5 à 1200, sont projetés sur le tapis défilant par l'intermédiaire d'un bras oscillant transversalement par rapport à la direction de défilement du tapis. Pour la technique de projection de fils continus, on peut par exemple se référer au WO 02084005. Chacun des fils projetés peut comprendre 20 à 500 fibres (en fait, filaments continus) unitaires. De préférence, le fil a un titre allant de 12,5 à 100 tex (g/km).

La matière constituant les fibres (filaments continus ) et donc les fils, est minérale et peut comprendre un verre fibrable tel que le verre E ou le verre décrit dans le FR2768144 ou un verre alcalino-résistant dit verre AR, lequel comprend au moins 5% en mole de ZrO₂. Notamment l'utilisation de verre AR mène à un mat renforçant efficacement les matrices en ciment ou pouvant renforcer les composites à matrice thermodurcissables devant venir en contact avec un environnement corrosif. Le verre peut également être exempt de bore. Par ailleurs, on peut également utiliser un mélange de fibres de verre et de fils en polymère comme en polypropylène, notamment les fils mixtes commercialisés sous la marque Twintex^{®} par Saint-Gobain Vetrotex France. Les fils utilisés pour réaliser le mat comprennent donc des fibres (filaments) de verre.

L'invention concerne également un procédé de fabrication de mat comprenant l'étape d'aiguilletage déjà décrite. Avant aiguilletage, les fils coupés ou continus sont déposés ou projetés sur un tapis défilant. A ce stade, les fils peuvent être secs, soit parce qu'ils proviennent de rovings (ou bobines), soit parce qu'ils ont été séchés après ensimage et avant l'aiguilletage selon l'invention. Cependant, la demanderesse a observé qu'il était avantageux que les fils soient un peu humides pour passer dans l'aiguilleteuse. Une trop forte humidité peut conduire à un encrassement.

Le mat selon l'invention peut subir au moins un séchage selon le cas. Si les fils utilisés sont secs au départ et que l'on n'imprègne les fils par aucun liquide, le séchage n'est pas nécessaire. Le séchage est nécessaire si les fils sont imprégnés d'un liquide à un moment de la fabrication du mat selon l'invention. Généralement, les fils sont fraîchement ensimés au moment de leur utilisation dans le procédé selon l'invention. Ainsi, il est possible de sécher les fils sur le tapis défilant avant l'aiguilletage. Cependant, comme déjà dit, on préfère conserver l'état imprégné pour l'aiguilletage et l'on sèche donc de préférence la nappe de fils seulement après l'aiguilletage. Le séchage peut être réalisé par passage du tapis défilant dans une étuve à une température allant de 40 à 170 °C et plus particulièrement de 50 à 150°C. Un tel traitement thermique ne produit pas de durcissement trop fort de l'ensimage des fils qui gardent toute leur souplesse.

Le mat selon l'invention peut être intégré à un complexe comprenant plusieurs couches juxtaposées. Notamment, le mat selon l'invention, dans sa variante utilisant des fils continus, peut constituer la couche à fils continus répartis de façon aléatoire de la structure fibreuse faisant l'objet du WO 03/060218 dont le texte est incorporé à la présente par référence. Plus particulièrement, le mat selon l'invention peut être incorporé dans un complexe multicouche à la structure suivante : mat selon l'invention + couche de fils coupés d'un côté du mat selon l'invention ou mat selon l'invention + couche de fils coupés des deux côtés dudit mat (complexe à 2 ou 3 couches). Ainsi, il est possible de déposer sur le tapis défilant une première couche de fibres (par exemple : fils coupés par exemple à une longueur entre 12 et 100 mm) puis de déposer sur cette couche les fils pour former le mat selon l'invention, puis de procéder à l'aiguilletage selon l'invention et ainsi lier ensemble par l'aiguilletage les deux couches entre elles. On peut également ajouter une troisième couche (par exemple : fils coupés par exemple à une longueur entre 12 et 100 mm) avant l'aiguilletage selon l'invention.

En fin de fabrication du mat, on peut éventuellement procéder à une découpe des bordures du ruban de mat formé, du fait que les bordures peuvent éventuellement présenter une structure ou densité un peu différente de la partie centrale.

On resterait dans le cadre de l'invention si l'on procédait de l'une des façons suivantes :
a) en liant les fibres du mat par un liant soluble dans l'eau (exemple : un alcool polyvinylique) avant l'aiguilletage puis en enlevant le liant par dissolution dans l'eau ou dans une solution aqueuse avant l'aiguilletage ;
b) en liant les fibres du mat par un liant soluble dans l'eau (exemple : un alcool polyvinylique) avant l'aiguilletage, puis en enlevant le liant par dissolution dans l'eau ou dans une solution aqueuse après l'aiguilletage ;
c) en déposant ou projetant les fils sur un film lui-même reposant sur un tapis défilant, puis en enroulant la nappe de fils non lié en même temps que le film (ce dernier empêchant les différentes couches enroulées de se mélanger), pour un éventuel stockage intermédiaire, puis en déroulant le bicouche film/nappe, en enlevant le film et en remettant la nappe sur un tapis défilant pour la poursuite du procédé selon l'invention ;

Le mat obtenu par le procédé selon l'invention ne contient pas de liant. Il est symétrique par rapport à un plan qui lui est parallèle et passe dans son milieu. Il a suffisamment de cohésion pour être enroulé en forme de rouleau et être déroulé pour utilisation.

L'invention mène notamment à un mat aiguilleté de fils continus ou de fils coupés (de préférence de fils continus) consistant en de la fibre minérale (notamment en verre) éventuellement ensimée et sans trous d'aiguille visibles à l'oeil nu. Ce mat contient donc un maximum de fibre minérale pour renforcer le plus possible le composite, en l'absence de matières synthétiques à base de polymères (PP, polyester, etc) non renforçantes pour le composite, hormis les éventuels composants organiques de l'ensimage des fibres. Ce mat est avantageusement utilisé pour renforcer un composite dans le procédé d'injection en moule fermé (RTM) ou dans le cadre de la technologie SMC, ou pour être imprégné directement de résine pour faire des plaques, notamment particulièrement translucides.

Le mat obtenu par le procédé selon l'invention peut être intégré dans un préimprégné en feuille (SMC). Le mat selon l'invention est alors inséré en continu entre deux couches de pâte de résine thermodurcissable. On déroule puis intègre ledit mat directement entre deux couches de pâte de résine. En plus du mat selon l'invention, on n'exclut pas d'ajouter d'autres couches de renfort dans le SMC, comme par exemple des fils coupés, notamment de verre. Par exemple, on peut procéder ainsi :
- déroulement à l'horizontale du mat selon l'invention sur une couche de pâte de résine, puis
- projection sur le mat de fils coupés, puis
- déroulement d'une couche de pâte de résine sur les fils coupés.

On peut également mettre une couche de fils coupés avant de dérouler le mat selon l'invention.

La feuille de SMC peut servir à la fabrication d'un matériau composite par moulage de la feuille par pression sur ses faces principales conduisant à un élargissement de la feuille dans le moule avant solidification de la résine. Pour le cas ou le mat est à fils continus, la feuille de SMC découpée a, avant moulage sous pression, de préférence une surface représentant 50 à 80 % de la surface du moule (et donc de la surface de la pièce finale).

Le fait qu'on n'utilise pas de liant chimique pour réaliser le mat selon l'invention permet de réaliser des composites particulièrement translucides. La demanderesse a en effet constaté que l'absence de liant améliorait notablement la translucidité du composite final. Pour réaliser de tels composites translucides, on peut notamment utiliser le procédé représenté sur la figure 4 du WO2005/054559.

L'extrait sec d'une composition peut se déterminer par évaporation en étuve à 110 °C pendant 12 heures. Le PVP pur a un extrait sec de 100%. Le PEG 400ML a un extrait sec de 100%. Dans le cas d'un silane, il s'agit bien entendu pour l'homme du métier de ce qui reste du silane après hydrolyse, et après évaporation de l'eau. L'homme du métier parle également de matière active. Le silane A174 a un extrait sec de 82% en poids. En partant de 10 g de silane non hydrolysé, en l'hydrolysant et en traitant l'hydrolysat en étuve à 110 °C pendant 12 heures, on récolte finalement 8,2 g d'extrait sec. Quand on dit que l'extrait sec d'une composition d'ensimage comprend 1 à 30% d'un agent de couplage, l'homme du métier comprend immédiatement que cet extrait sec ne contient pas exactement le produit tel que fourni par le fabriquant, mais qu'il s'agit d'un résidu hydrolysé puis déshydraté de ce produit On pourrait donc dire de façon équivalente que l'extrait sec de la composition comprend 1 à 30% en poids issu d'un agent de couplage.

### EXEMPLES 1-5

Dans les exemples qui suivent on compare des ensimages selon l'invention à un ensimage classique et à un ensimage sans PVP.

L'ensimage classique (pour l'exemple 1) comprenait dans son extrait sec (ce dernier représentant 4% de la composition d'ensimage) :
- 5% en poids de silane A174
- 91% en poids de film former Neoxyl
- 3,9 % en poids de lubrifiant Antarox.

Les autres compositions d'ensimage comprenaient 1,3% en poids d'extrait sec comprenant lui-même 6,4% en poids de silane A174 et 50 ppm en poids d'un agent antimousse (de marque Agitan 295 commercialisé par Munzing Chemie). Les autres ingrédients de cet extrait sec sont indiqués dans la deuxième colonne du tableau 1 et il s'agit soit de PVP de masse moléculaire moyenne en masse 900 000, soit de PEG 400 ML, soit d'un mélange comme indiqué de ces deux composants. Ainsi, PVP 100% indique que le reste de l'extrait sec hors silane et agent antimousse est constitué de 100% de PVP.

Avec du fil de verre continu ensimé avec ces compositions, on a réalisé des mats à fils continu par projection en nappe sur un convoyeur en mouvement. La projection était réalisée à l'aide d'un dispositif sur le principe de celui de la figure 4 du US3969171. L'aiguilletage était réalisé conformément à la figure 3 du WO2005/054559, avec une densité de coups de 3 coups par cm².

Des composites ont ensuite été réalisés par imprégnation des différents mats à l'aide d'une résine thermodurcissable et selon le procédé RTM.

Le tableau 1 ci-dessous rassemble les résultats. On a comparé les différents ensimages sur le plan du comportement du fil ou du mat lors de différentes étapes du procédé ainsi qu'au niveau de la qualité du composite final. Il s'agit d'appréciations relatives. Ce comportement était noté de - - (note minimale) à + + (note maximale). Les comportements suivants ont été observés :
- le comportement lors de la dépose du fil continu en nappe : dans le cas de l'exemple 3, la dépose était difficile car le fil glissait trop sur les roues du dispositif de projection, de sorte que l'étirement du fil était difficilement maîtrisable ;
- le comportement à l'aiguilletage : deux défauts ont été observés, la cassure de fils dans le cas de l'exemple 1, ou l'impossibilité d'aiguilleter dans le cas de l'exemple 3 ; dans ce dernier cas, le fil s'est avéré trop glissant et le fil revenait trop fréquemment lorsque les aiguilles ressortaient du mat, ce qui équivaut à la quasi absence d'aiguilletage et c'est pourquoi le mat n'avait pas de tenue suffisante ;
- la déformabilité à la main dans le moule d'imprégnation : elle était acceptable pour tous les exemples, un peu inférieure cependant dans le cas de l'exemple 2 ;
- la translucidité du composite final.

| **Ex n°** | **ensimage** | **Dépose en nappe** | **Aiguilletage** | **Déformabilité à la main** | **Translucidité Composite final** |
|---|---|---|---|---|---|
| 1 | classique | + + | -- (cassures) | - | - |
| 2 | PVP : 100% | + + | + + | + | ++ |
| 3 | PEG : 100% | - | -- (ne tient pas) | + + | |
| 4 | PVP/PEG : 50/50 | + + | + + | + + | ++ |
| 5 | PVP/PEG : 75/25 | + + | + + | + + | ++ |

## Revendications

1. Mat de fils aiguilleté comprenant un fil en verre minéral ensimé par une composition comprenant de l'eau, l'extrait sec de ladite composition comprenant 1 à 30% en poids d'un agent de couplage et 30 à 99% en poids de polyvinylpyrrolidone.

2. Mat selon la revendication précédente, **caractérisé en ce que** les fils sont continus.

3. Mat selon l'une des revendications précédentes, **caractérisé en ce que** l'extrait sec de ladite composition comprend 2 à 10% en poids d'un agent de couplage.

4. Mat selon l'une des revendications précédentes, **caractérisé en ce que** l'extrait sec de ladite composition comprend 30 à 90% en poids de polyvinylpyrrolidone.

5. Mat selon l'une des revendications précédentes, **caractérisé en ce que** l'extrait sec de ladite composition comprend un lubrifiant dont la teneur est inférieure à 79% en poids.

6. Mat selon la revendication précédente, **caractérisé en ce que** la teneur du lubrifiant va de 5 à 70% dans l'extrait sec.

7. Mat selon la revendication précédente, **caractérisé en ce que** la teneur du lubrifiant va de 20 à 70% dans l'extrait sec.

8. Mat selon l'une des revendications précédentes, **caractérisé en ce que** l'extrait sec de ladite composition comprend 5 à 500 ppm en poids d'agent anti-mousse.

9. Mat selon l'une des revendications précédentes, **caractérisé en ce que** ladite composition ne contient pas de résine epoxy.

10. Mat selon l'une des revendications précédentes, **caractérisé en ce que** l'extrait sec de ladite composition représente entre 0,5 et 10% en poids de ladite composition.

11. Mat selon la revendication précédente, **caractérisé en ce que** l'extrait sec de ladite composition représente entre 0,8 et 6% en poids de ladite composition.

12. Mat selon la revendication précédente, **caractérisé en ce que** l'extrait sec de ladite composition représente entre 0,8 et 2% en poids de ladite composition.

13. Mat selon l'une des revendications précédentes, sous forme de rouleau.

14. Procédé de préparation d'un mat de l'une des revendications précédentes comprenant
a) la dépose ou projection de fils en verre minéral ensimés par la composition sur un tapis défilant pour former une nappe desdits fils entraînée par ledit tapis, puis
b) l'aiguilletage par des aiguilles à barbes traversant ladite nappe et se déplaçant dans la direction de la nappe à sensiblement la même vitesse qu'elle lorsqu'elles la traversent, avec une densité de coups allant de 1 à 25 coups par cm².

15. Procédé de préparation d'un matériau composite à matrice thermodurcissable comprenant l'imprégnation d'un mat de l'une des revendications de mat précédentes par une résine thermodurcissable.

16. Procédé selon la revendication précédente, **caractérisé en ce qu'**il est à injection en moule fermé (RTM).

17. Procédé de préparation d'une feuille de préimprégné (SMC) comprenant l'insertion en continu d'un mat de l'une des revendications de mat précédentes entre deux couches de pâte de résine thermodurcissable.

18. Feuille de préimprégné comprenant un mat de l'une des revendications de mat précédentes et une résine thermodurcissable.

19. Procédé de fabrication d'un matériau composite par moulage de la feuille de la revendication précédente par pression sur ses faces principales conduisant à un élargissement de la feuille avant solidification de la résine.

20. Matériau composite à matrice thermodurcissable renforcé par un mat de l'une des revendications de mat précédentes.

## Claims

1. Needled strand mat comprising a mineral glass strand lubricated by a composition comprising water, the dry solid content of said composition comprising 1 to 30% by weight of a coupling agent and 30 to 99% by weight of polyvinylpyrrolidone.

2. Mat according to the preceding claim, **characterized in that** the strands are continuous.

3. Mat according to one of the preceding claims, **characterized in that** the dry solid content of the composition comprises 2 to 10% by weight of a coupling agent.

4. Mat according to one of the preceding claims, **characterized in that** the dry solid content of said composition comprises 30 to 90% by weight of polyvinylpyrrolidone.

5. Mat according to one of the preceding claims, **characterized in that** the dry solid content of said composition comprises a lubricant the quantity of which is less than 79% by weight.

6. Mat according to the preceding claim, **characterized in that** the lubricant content ranges from 5 to 70% in the dry solid content.

7. Mat according to the preceding claim, **characterized in that** the lubricant content ranges from 20 to 70% in the dry solid content.

8. Mat according to one of the preceding claims, **characterized in that** the dry solid content of said composition comprises 5 to 500 ppm by weight of antifoaming agent.

9. Mat according to one of the preceding claims, **characterized in that** said composition does not contain epoxy resin.

10. Mat according to one of the preceding claims, **characterized in that** the dry solid content of said composition represents between 0.5 and 10% by weight of said composition.

11. Mat according to the preceding claim, **characterized in that** the dry solid content of said composition represents between 0.8 and 6% by weight of said composition.

12. Mat according to the preceding claim, **characterized in that** the dry solid content of said composition represents between 0.8 and 2% by weight of said composition.

13. Mat according to one of the preceding claims, in the form of a roll.

14. Method for preparing a mat of one of the preceding claims comprising
a) depositing or spraying mineral glass strands lubricated by the composition onto a conveyer belt to form a sheet of said strands driven by said belt, then
b) needling with barbed needles passing through said sheet and moving in the direction of the sheet at substantially the same speed as the speed at which the needles pass through the sheet, with a stroke density ranging from 1 to 25 strokes per cm².

15. Method for preparing a composite material with a thermosetting matrix comprising the impregnation of a mat of one of the preceding mat claims by a thermosetting resin.

16. Method according to the preceding claim, **characterized in that** it is a closed-mold injection (RTM).

17. Method for preparing a pre-impregnated sheet (SMC) comprising the continuous insertion of a mat of one of the preceding mat claims between two layers of thermosetting resin paste.

18. Pre-impregnated sheet comprising a mat of one of the preceding mat claims and a thermosetting resin.

19. Method for manufacturing a composite material by molding the sheet of the preceding claim by pressure on its main faces causing the sheet to spread out before the resin solidifies.

20. Composite material with thermosetting matrix reinforced by a mat of one of the preceding mat claims.

## Patentansprüche

1. Vernadelte Fasermatte, die eine mineralische Glasfaser umfaßt, welche mit einer Wasser enthaltenden Zusammensetzung geschlichtet ist, wobei der Trockenextrakt der Zusammensetzung 1 bis 30 Gew.-% eines Kopplungsmittels sowie 30 bis 99 Gew.-% Polyvinylpyrrolidon umfaßt.

2. Matte nach dem vorhergehenden Anspruch, **dadurch gekennzeichnet, daß** die Fasern endlos sind.

3. Matte nach einem der vorhergehenden Ansprüche, **dadurch gekennzeichnet, daß** der Trockenextrakt der Zusammensetzung 2 bis 10 Gew.-% eines Kopplungsmittels umfaßt.

4. Matte nach einem der vorhergehenden Ansprüche, **dadurch gekennzeichnet, daß** der Trockenextrakt der Zusammensetzung 30 bis 90 Gew.-% Polyvinylpyrrolidon umfaßt.

5. Matte nach einem der vorhergehenden Ansprüche, **dadurch gekennzeichnet, daß** der Trockenextrakt der Zusammensetzung ein Schmiermittel umfaßt, dessen Gehalt unter 79 Gew.-% liegt.

6. Matte nach dem vorhergehenden Anspruch, **dadurch gekennzeichnet, daß** der Gehalt des Schmiermittels in dem Trockenextrakt zwischen 5 und 70 % liegt.

7. Matte nach dem vorhergehenden Anspruch, **dadurch gekennzeichnet, daß** der Gehalt des Schmiermittels in dem Trockenextrakt zwischen 20 und 70 % liegt.

8. Matte nach einem der vorhergehenden Ansprüche, **dadurch gekennzeichnet, daß** der Trockenextrakt der Zusammensetzung 5 bis 500 Gew.-ppm eines Antischaummittels enthält.

9. Matte nach einem der vorhergehenden Ansprüche, **dadurch gekennzeichnet, daß** die Zusammensetzung kein Epoxydharz umfaßt.

10. Matte nach einem der vorhergehenden Ansprüche, **dadurch gekennzeichnet, daß** der Trockenextrakt der Zusammensetzung 0,5 bis 10 Gew.-% der Zusammensetzung ausmacht.

11. Matte nach dem vorhergehenden Anspruch, **dadurch gekennzeichnet, daß** der Trockenextrakt der Zusammensetzung zwischen 0,8 und 6 Gew.-% der Zusammensetzung ausmacht.

12. Matte nach dem vorhergehenden Anspruch, **dadurch gekennzeichnet, daß** der Trockenextrakt der Zusammensetzung zwischen 0,8 und 2 Gew.-% der Zusammensetzung ausmacht.

13. Matte nach einem der vorhergehenden Ansprüche, in Form einer Rolle.

14. Verfahren zur Herstellung einer Matte aus einem der vorhergehenden Ansprüche, das folgendes umfaßt:
a) das Auflegen oder Aufspritzen von mit der Zusammensetzung geschlichteten, mineralischen Glasfasern auf ein vorbeilaufendes Band, um eine durch das Band vorwärtsbewegte Lage aus den Fasern zu bilden, anschließend
b) das Vernadeln durch Hakennadeln, welche die genannte Lage durchgreifen und sich in der Richtung der Lage im wesentlichen mit der gleichen Geschwindigkeit wie diese, wenn sie sie durchgreifen, mit einer Stichdichte zwischen 1 und 25 Stichen pro cm² bewegen.

15. Verfahren zur Herstellung eines Verbundwerkstoffs mit duroplastischer Matrix, das das Imprägnieren einer Matte aus einem der vorhergehenden Matten-Ansprüche mit einem warm härtbaren Harz umfaßt.

16. Verfahren nach dem vorhergehenden Anspruch, **dadurch gekennzeichnet, daß** es ein Spritzverfahren in geschlossener Form (RTM) ist.

17. Verfahren zur Herstellung einer Prepreg-Folie (SMC), das das fortlaufende Einführen einer Matte aus einem der vorhergehenden Matten-Ansprüche zwischen zwei Schichten aus einer Paste aus warm härtbarem Harz umfaßt.

18. Prepreg-Folie, die eine Matte aus einem der vorhergehenden Matten-Ansprüche sowie ein warm härtbares Harz umfaßt.

19. Verfahren zur Herstellung eines Verbundwerkstoffs durch Formen der Folie des vorhergehenden Anspruchs durch Druck auf deren Hauptflächen, was zu einer Verbreiterung der Folie vor der Verfestigung des Harzes führt.

20. Verbundwerkstoff mit duroplastischer Matrix, der durch eine Matte aus einem der vorhergehenden Matten-Ansprüche verstärkt ist.
